# EUROPEAN PATENT APPLICATION

(11) **EP 2 085 683 A1**
(43) Date of publication of application: **05.08.2009**
(21) Application number: 07800789.5
(22) Date of filing: 24.08.2007
(51) Int. Cl.: F21S 2/00, F21S 8/00, F21Y 101/02, H01L 33/00

(54) **LIGHT EMITTING SYSTEM**

(30) Priority: 13.11.2006 WO PCT/CN2006/003037; 22.06.2007 WO PCT/CN2007/001966
(71) Applicant: Hong-Yuan Technology Co., Ltd., Yonghe City, Taipei County, Taiwan 234 (TW)
(72) Inventor: WU, Yu-Chao, Taiwan 234 (CN)
(74) Representative: 2K Patentanwälte Blasberg Kewitz & Reichel
(86) International application number: PCT/CN2007/002570
(87) International publication number: WO 2008/058446

(57) **Abstract**

A light emitting system comprises at least one light module(100), which includes a supporting substrate (102); a plurality of light emitting arrays (130) supported on the supporting substrate (102), in which each light emitting array (130) comprises a plurality of light emitting chips (104) which are not modular, and each light emitting array (130) is arounded by a light reflecting structure (110); and a lens (200) provided on the light emitting arrays (130) to adjust the light emitted from the light emitting arrays (130) and form a light source.

## Description

### Field of the Technology

The present invention relates to a light emitting system, light emitting apparatus and forming method thereof, and in particular to a light emitting system, light emitting apparatus, which have light emitting rows, and forming method thereof.

### Background of Technology

Light emitting diodes (LED) have been widely applied in many display products because their high brightness, small size, durability, low power consumption and long operating lifespan. The principle operation of an LED is described as followed. A voltage is applied to a diode to drive a combination of electrons and holes in the diode, and releases energy in the form of a photon. Additionally, fluorescent features may be added into the LED to adjust wavelength (color) or intensity of the emitted light.

White light LEDs have been widely applied in illumination products. Compared with the conventional incandescent lamps and fluorescent lamps, white light LEDs have advantages of lower heat, lower power consumption, longer operating lifespan, faster response time and smaller size. Therefore, white light LEDs are expected to be used mainstream in illumination products moving forward.

Because light emitting efficiency and heat dissipation considerations, the conventional light emitting module is formed by a package comprising a single light emitting chip surrounded by a reflective cup. The conventional light emitting module prevents the heat dissipation problem experienced by multi-chips on a substrate. Additionally, the conventional light emitting module prevents light emitted from sides of a light emitting chip to be blocked by that of an adjacent light emitting chip, which if not prevented, would reduce light emitting efficiency. However, the conventional light emitting chip package increases the conventional light emitting module dramatically for a plurality of light emitting chips. Because the conventional light emitting chip package can not be reduced, an improved substrate and light emitting module is needed.

### Content of the Invention

To solve the above-described problems, a light emitting system is provided. An exemplary embodiment of a light emitting system comprising at least a light emitting module comprises a substrate, and light emitting rows supported by the substrate, wherein each light emitting row has unassembled light emitting chips, surrounded by a reflective structure, and a transparent lens is disposed above the light emitting rows for mixing lights emitted from the light emitting rows to form a light source.

Each light emitting row may comprise unassembled light emitting chips. Therefore, area of the light emitting module can be reduced. Additionally, each light emitting row may be surrounded by a reflective structure. Therefore, light emitting efficiency of the light emitting module can be improved.

In another exemplary embodiment of a light emitting system, the light emitting module further comprises a light emitting material layer in at least one of the light emitting rows, covering the unassembled light emitting chips.

In another exemplary embodiment of a light emitting system, the light emitting material layer further comprises light emitting powders, wherein at least one part of the light emitting powders is clotted without adhesive.

In another exemplary embodiment of a light emitting system, the light emitting module further comprises a protective layer mounted in the reflective structure, covering the light emitting material layer.

In another exemplary embodiment of a light emitting system, the light emitting material layer continuously covers the unassembled light emitting chips, and extends to an inner wall of the reflective structure.

In another exemplary embodiment of a light emitting system, a bottom of the reflective structure is bonded to the substrate by an adhesive, and the adhesive is mixed with light emitting powders.

In another exemplary embodiment of a light emitting system, a first light emitting chip and an adjacent second light emitting chip of at least one of the light emitting rows have a minimum distance, wherein each of the first light emitting chip and the second light emitting chip comprises at least one side, the minimum distance makes a projection plane of the side of the first light emitting chip and the side of the second light emitting chip substantially not overlapped.

In another exemplary embodiment of a light emitting system, a first light emitting chip and an adjacent second light emitting chip of at least one of the light emitting rows have a minimum distance, wherein each of the first light emitting chip and the second light emitting chip comprises at least one side, and the minimum distance makes an overlapped portion between a projection plane of the side of the first light emitting chip and the side of the second light emitting chip substantially smaller than 70% of the projection plane of the side of the first light emitting chip.

In another exemplary embodiment of a light emitting system, a light emitting chip of at least one of the light emitting rows comprises sides, and an incident light emitted by each side of the light emitting chip faces to a side of the reflective structure without being blocked by the other light emitting chips.

In another exemplary embodiment of a light emitting system, the light emitting chip of at least one of the light emitting rows comprises two vertices on a diagonal, and the two vertices are on an axis parallel to the reflective structure or on a line parallel to the axis.

In another exemplary embodiment of a light emitting system, the light emitting rows comprise a light emitting row emitting light with greater color temperature and a light emitting row emitting light with lower color temperature.

In another exemplary embodiment of a light emitting system, at least one light emitting row is covered by a light emitting material layer and emits a first light in the reflective structure, and at least one light emitting row not comprising the light emitting material layer emits a second light, wherein the first light and the second light are mixed by the transparent lens to form a third light.

In another exemplary embodiment of a light emitting system, the substrate comprises a metal substrate, and the substrate further comprises a metal insulating layer thereon, wherein the metal insulating layer further comprises a patterned conductive layer to electrically connect the light emitting chips, and an interface between the patterned conductive layer and the metal insulating layer does not comprise a sealing layer or an insulating oil film.

In another exemplary embodiment of a light emitting system, the metal insulating layer has holes, and the holes are covered by an insulating oil film.

In another exemplary embodiment of a light emitting system, a top surface of the metal insulating layer totally does not comprise the sealing layer or an insulating oil film formed thereon.

In another exemplary embodiment of a light emitting system, the substrate comprises an aluminum substrate, and the metal insulating layer comprises a porous aluminum oxide layer without a hydro-thermal sealing process or cured material sealing process.

In another exemplary embodiment of a light emitting system, the patterned conductive layer is formed by curing a silver paste.

In another exemplary embodiment of a light emitting system, the insulating oil film is formed by methylsilicon oil.

In another exemplary embodiment of a light emitting system, the substrate is formed by a silicon carbide material.

In another exemplary embodiment of a light emitting system, a projection plane of the transparent lens facing to the substrate has a polygonal shape.

In another exemplary embodiment of a light emitting system, a first light emitting row emits a first light with a first color temperature, and a second light emitting emits a second light with a second color temperature, wherein the first light and the second light are mixed by the transparent lens to form a third light with a third color temperature, and the third color temperature is between the first and second color temperatures.

In another exemplary embodiment of a light emitting system, the transparent lens comprises rectangular, square, hexagonal or octagonal transparent lens, and the substrate outside of the transparent lens further comprises a circuit region thereon.

In another exemplary embodiment of a light emitting system, the light emitting module further comprises a frame mounted on the substrate, the frame comprises an inner frame surrounding the light emitting rows serving as a reflective structure, and an outer frame surrounds the circuit region.

In another exemplary embodiment of a light emitting system, a dimension of the transparent lens is smaller than the frame, and an inner surface of the transparent lens facing to the light emitting rows is a rough surface.

In another exemplary embodiment of a light emitting system, the light emitting module further comprises a circuit pattern on the substrate to electrically connect to the light emitting chips, and extend to a region of the substrate outside of the reflective structure, and a conductive block on the region of the substrate outside of the reflective structure to electrically connect to the circuit pattern.

Another exemplary embodiment of a light emitting system further comprises a shell body having a opening, a supporting plate mounted on the opening of the shell body to form an accommodation space, wherein the light emitting module is mounted on an outer side of the supporting plate by a collapsible method, and the accommodation space comprises a heat dissipation portion therein and is bonded to an inner side of the supporting plate.

In another exemplary embodiment of a light emitting system, the heat dissipation portion further comprises heat pipes bonded to the inner side of the supporting plate, wherein the supporting plate serves as a heat dissipation plate, and heat slugs bond to the inner side of the supporting plate with the heat pipes embedded therein.

Another exemplary embodiment of a light emitting system further comprises cooling fins or a cellular ceramic cooling structure bonded to the inner side of the supporting plate and the heat slugs.

In another exemplary embodiment of a light emitting system further comprises a heat dissipation device without power bonded on the shell body or in the accommodation space.

In another exemplary embodiment of a light emitting system, the light emitting row surrounded by at least one the reflective structures comprises at least two light emitting chips.

In another exemplary embodiment of a light emitting system, one light emitting chip of at least one the light emitting rows comprises two connecting sides, and the two connecting sides face a sidewall of the reflective structure with a tilted angle.

In another exemplary embodiment of a light emitting system, one light emitting chip of at least one the light emitting rows comprises a long side and a short side, wherein a light emitted from the long side of the light emitting chip substantially faces a sidewall of the reflective structure or faces a sidewall of the reflective structure with a tilted angle, without being blocked by the other light emitting chips.

One embodiment of a light emitting system of the invention may improve light emitting efficiency and heat dissipation efficiency.

### Description of the Drawing

FIG. 1A is a cross section showing a portion of an embodiment of a light emitting module of the invention.
FIGS. 1B to 1D show cross sections of an embodiment of a substrate of the invention.
FIG. 2A is a cross section showing a portion of another embodiment of a light emitting module of the invention
FIG. 2B shows an arrangement of an embodiment of light emitting chips in light emitting rows as shown in FIG. 1A.
FIG. 2C shows an arrangement of another embodiment of light emitting chips in light emitting rows as shown in FIG. 1A.
FIG. 3 shows an assembling diagram of an embodiment of a light emitting module of the invention.
FIG. 4 shows an assembling diagram of another embodiment of a light emitting module of the invention.
FIGS. 5A to 5B show cross sections of an embodiment of a transparent lens of the invention.
FIG. 6 shows an assembling diagram of an embodiment of a light emitting module and a transparent lens of the invention.
FIG. 7 shows a diagram of an embodiment of illumination equipment constructed by light emitting modules.
FIG. 8 shows a heat dissipation portion used in an embodiment of illumination equipment as shown in FIG. 7.
FIG. 9 shows a heat dissipation portion used in another embodiment of illumination equipment as shown in FIG. 7.
FIG. 10 shows a heat dissipation portion used in another embodiment of illumination equipment as shown in FIG. 7.
FIG. 11 shows a diagram of an embodiment of a light emitting module which emits lights with various color temperatures.
FIG. 12 shows a diagram of another embodiment of a light emitting module which emits lights with various color temperatures.

### Best Embodiments

The invention can be more fully understood by reading the subsequent detailed description and examples with references made to the accompanying drawings.

Embodiments of the invention herein incorporate PCT patent application Ser. number PCT/CN 2007/001966 and PCT patent application Ser. number PCT/CN 2006/003037 by the inventor for references.

The following embodiments describe a method for fabricating a substrate, and a light emitting module having a reflective structure and a heat dissipation method thereof, and an illumination device constructed by light emitting modules, wherein it is to be understood that the invention is not limited to the disclosed embodiments.

In the specification, the term "reflective structure" indicates a closed structure. In one embodiment, a region surrounded by the reflective structure may have, for example, a rectangular or square shape, but is not limited to the disclosed embodiments. Also, the region surrounded by the reflective structure may have a circular shape. Alternatively, the region surrounded by the reflective structure may have an arbitrary shape.

In one embodiment, the reflective structure may collect light emitted form sides of light emitting chips. The light emitting chips may be constructed by light emitting diodes, which can emit a specific light. The unassembled light emitting chips usually mean that the light emitting chips are not configured with a sealing layer or a reflective cup, or the light emitting chips are bare chips. Additionally, a row of the light emitting rows indicates a space substantially along a specific direction, but is not limited to a longitudinal direction, transverse direction or line direction.

### Light emitting module having a reflective structure

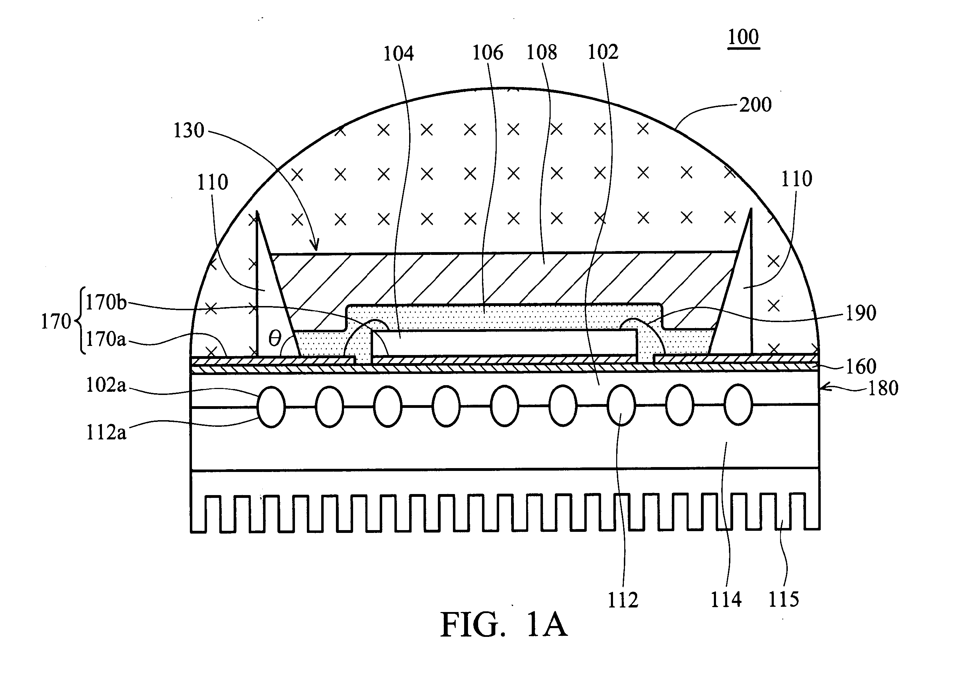

FIG. 1A shows an embodiment of a light emitting module having a reflective structure of the invention. A light emitting module 100 comprises a substrate 102 used to support at least one light emitting row 130. Each light emitting row 130 has unassembled light emitting chips 104, for example, light emitting diode chips. Each light emitting row 130 is surrounded by a reflective structure 110. The reflective structure 110 comprises a row space corresponding to the reflective structure to mount the light emitting chips 104 on the substrate 102 in the row space. In another embodiment, each light emitting row 130 may further comprise an inner covering layer 108 mounted in the reflective structure 110, covering the light emitting chips 104. The unassembled light emitting chips usually mean that the light emitting chips are not configured with a sealing layer or a reflective cup, or the light emitting chips are bare chips. Therefore, previous area required is not needed Because the unassembled light emitting chips and area of the light emitting module may be reduced. Additionally, the light emitting chips may be arranged in many light emitting rows, and each light emitting row may be surrounded by a reflective structure. When compared with each light emitting chip being surrounded by a ring-shaped reflective structure, each light emitting row of one embodiment of the light emitting chips and the reflective structure may have a shorter distance. Also, a light emitted from a light emitting chip may irradiate to the adjacent reflective structure more easily, without being blocked by other light emitting chips.

Additionally, at least one light emitting row may optionally comprise a light emitting material layer 106 in at least one of the light emitting rows, covering the light emitting chips 104. For example, the light emitting material layer 106 may be constructed of fluorescent powders. In one embodiment, the light emitting material layer 106 may continuously cover the unassembled light emitting chips 104, and extend to an inner wall of the reflective structure 110. In one embodiment, at least one part of the light emitting material layer 106 may be clotted without adhesive. For example, at least one part of the light emitting material layer 106 may be clotted by Van der Waals force through a baking method. In one embodiment, the light emitting material layer 106 may totally cover a top surface and sides of the light emitting chips 104 in a light emitting row. In another embodiment, the light emitting module may further comprise an inner covering layer 108 mounted in the reflective structure 110, covering the light emitting chips 104. The inner covering layer 108 may serve as a protective layer.

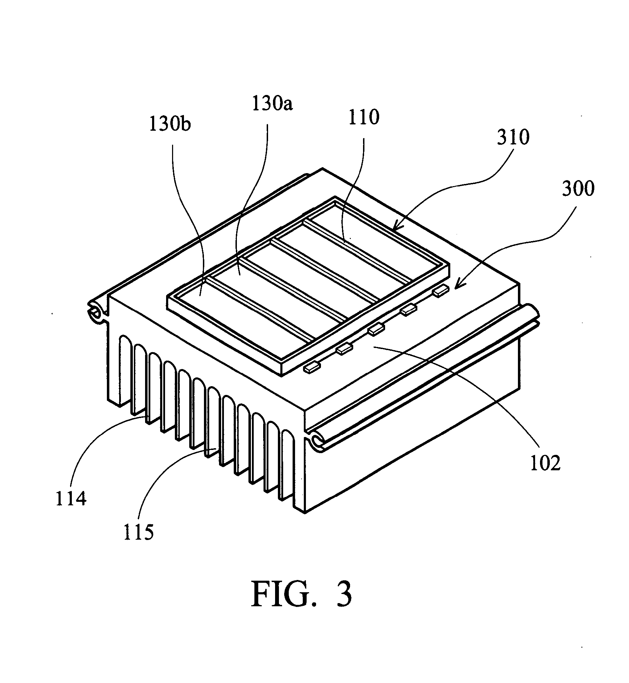

Referring to FIG. 3, a region surrounded by the reflective structure 110 may have a polygonal shape, for example, a rectangular or pentagonal shape. Also, the region surrounded by the reflective structure 110 may have a circular or elliptic shape.

Generally speaking, the inner covering layer (protective layer) 108 may be formed by coating soft polymer materials such as silicone in the reflective structure 110. Also, the inner covering layer (protective layer) 108 may be formed by embedding a hard glass layer, epoxy or other transparent plastic material layers, for example, polycarbonate (PC) or polyethylene (PE), into the reflective structure 110 and be laminated on the light emitting chips 104 or the light emitting material layer 106. The inner covering layer (protective layer) 108 is used to prevent the light emitting material layer 106 from peeling or water vapor permeation.

A direction of emitting light from the light emitting chip 104 may be adjusted by the reflective structure 110 using, for example, blocking, reflecting, collecting or focusing methods. Therefore, when the light emitting material layer 106 does not totally cover the sides of the light emitting chips 104, light leakage on the sides of the light emitting chips 104 may not be an issue, and color shift problem of the light emitting chips 104 may be improved.

The reflective structure 110 may generally comprise a metal material with a reflective plane or a plastic feature with a reflective material layer formed thereon. For example, the reflective structure 110 may comprise a plastic feature with Cr, Ni, Ag, ZnF or MgSO₄ formed thereon using a selective electroplating method.

Because the reflective structure 110 and the light emitting chip 104 are disposed on a plane, the heat dissipation efficiency of the light emitting module may be improved if the reflective structure 110 is a material of better heat dissipation efficiency, for example, a metal layer with a reflective plane formed by surface polishing.

Additionally, a transparent lens 200 may be disposed above the light emitting rows 130, covering the substrate 102, the light emitting chip 104, the inner covering layer (protective layer) 108 and the reflective structure 110, for mixing lights emitted from the light emitting rows 130 to form a light source. Besides silicon, the transparent lens 200 may comprise other materials, for example, PC, PE, acrylic, glass, and polycarbonate for light transparency requirements. Light transparency is related to wavelength of light, different wavelengths of light correspond to different light transparencies. The transparent lens 200 may also comprise colored transparent lenses to improve light contrast. In one embodiment, the transparent lens 200 may be closely bonded to an outer frame of the substrate 102 or the reflective structure 110 to form a closed-chamber. The closed-chamber may comprise a vacuum atmosphere or be filled with inert gas for stability. In another embodiment, another inner covering layer may be filled in the closed-chamber above the protective layer 108, further filling in a space above the reflective structure 110 to avoid water vapor permeation. In yet another embodiment, the protective layer may be formed after covering the transparent lens 200 on the substrate 102 by filling silicon to cover the light emitting material layer 106 and fill the closed-chamber. Therefore, forming an integral protective layer without an interface.

In another embodiment, an inner side of the reflective structure 110 and a surface of the substrate 102 may have an angle θ between about 0° to 90°, preferably about 45°. The reflective structure 110 may comprise metal, for example, stainless steel. The reflective structure 110 may comprise plastic or resin, for example, silicon. Additionally, the reflective structure 110 may comprise other materials, for example, PC, PE, acrylic, glass, and polycarbonate. A coating layer may be selectively formed on a surface of the reflective structure 110 for reflection.

In one embodiment, no glue is between the fluorescent powders in the light emitting material layer 106. Therefore, the light emitting efficiency may be improved. The number of light emitting chips 104 may be defined by requirements. In this embodiment, the chip is a light emitting diode.

Additionally, in other embodiments, a region surrounded by the reflective structure 110 may have a shape that is defined by requirements, for example, a rectangular shape, circular shape or the like. The shape of the reflective structure 110 may be arbitrarily designed, and the shape of the cross section of the reflective structure 110 may comprise of, for example, a trapezoid, triangle, arc or the like. In other embodiments, a region surrounded by the reflective structure 110 may have arbitrary shapes. For example, a stripe-shaped reflective structure 110 may be formed to match space for back light modules.

### Substrate

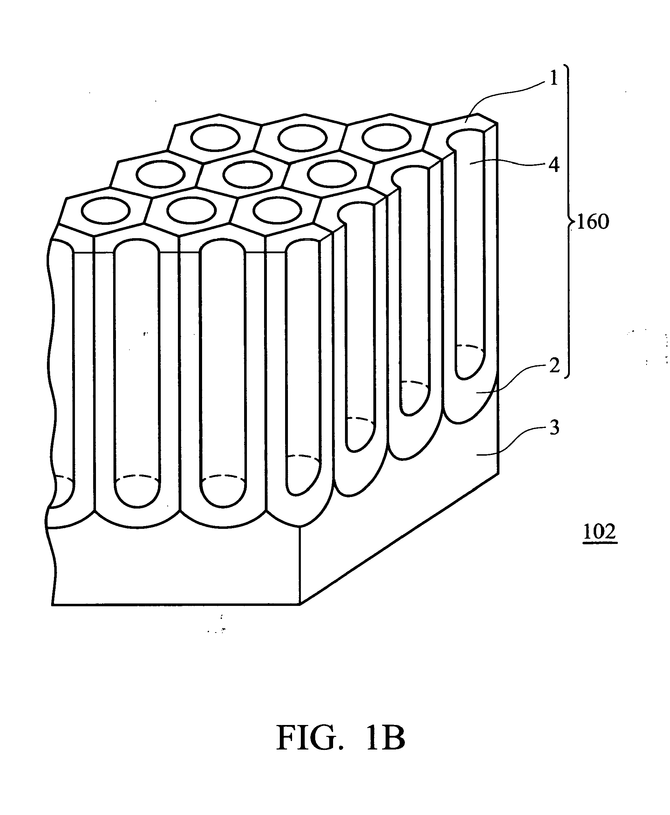

Referring to FIG. 1A, in one embodiment, the substrate 102 may comprise metal materials, for example, aluminum (Al). In other embodiments, the substrate 102 may comprise silicon carbide (SiC) or ceramic materials having aluminum oxide (Al₂O₃). Other ceramic materials having better heat conductivity may also be used for the substrate 102. Additionally, in one embodiment, a metal insulating layer 160 comprising one or more than one exposed holes, for example, a metal oxide layer, may be formed on a surface of the substrate 102 as shown in FIG. 1B. In one embodiment, the metal insulating layer 160 may be formed by anodizing an aluminum (Al) substrate 3 to form a porous aluminum oxide layer 1 with a thickness of about 30µm to 50µm. The porous aluminum oxide layer 1 may comprise a plurality of cell-shaped holes 4. The porous aluminum oxide layer 1 is isolated from the Al substrate 3 by a barrier layer 2.

The aforementioned formation of the metal insulating layer 160 may reduce heat resistance of the substrate 102 because the metal insulating layer 160 and the substrate 102 are bonded closely. Therefore, heat dissipation efficiency of the substrate 102 may be improved. In other words, the substrate 102 may have better heat dissipation efficiency. Therefore, one embodiment of the substrate 102 of the invention may improve the problem of heat dissipation for many chips disposed on a substrate.

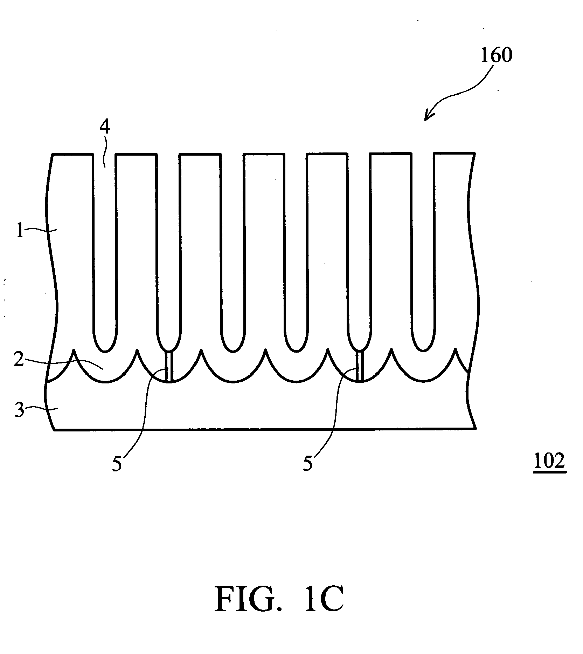

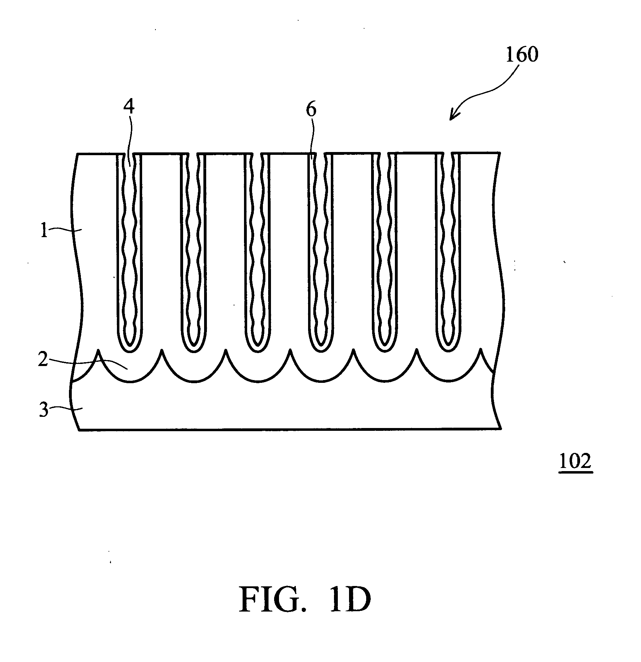

It should be noted that when manufacturing a porous aluminum insulating layer, characteristics of low hardness or impurities sticking to the surface may occur without a sealing process. Therefore, those having ordinary skill in the art may perform a sealing process to the anodized substrate before performing subsequent processes (for example, forming circuit patterns). In the case of an Al substrate with an aluminum oxide layer, the sealing process may comprise a hydro-thermal sealing process or a cured material sealing process. The hydro-thermal sealing process is performed by immersing the Al substrate into hot water with a temperature above about 90°C for 30 minutes to 60 minutes. The aluminum oxide layer of the Al substrate may react with water to form alumina hydrate, sealing the hole of the aluminum oxide layer. Therefore, forming a sealing layer and improving wear resistance of the Al substrate. Generally, the cured material sealing process is performed by coating a resin or melting a paraffin wax to seal the hole of the aluminum oxide layer. Next, the coated resin or melted paraffin wax is cured to form a sealing layer. When the aluminum oxide layer, after the sealing process is performed, is subjected to a subsequent thermal process, however, the aluminum oxide layer is easily broken because of water evaporation or the stress resulting from the thermal expansion coefficient difference among the sealing layer, the Al substrate and the aluminum oxide layer. A break 5 may be formed as shown in FIG. 1C, and a leakage path may occur. In one embodiment, to prevent such a break from occurring, the anodized substrate is not subjected the hydro-thermal sealing process or cured material sealing process, but immersed in an insulating oil as shown in FIG. 1D before forming a subsequent patterned conductive layer by the thermal process. After the insulating oil film covers the holes 4, the remaining insulating oil film on a top surface of the substrate is then removed. Therefore, no sealing layer or insulating oil film is above the top surface of the substrate before a patterned conductive layer is formed by the thermal process. The insulating oil may have a temperature range from a room temperature to 150°C, preferably below about 300°C.

### Patterned conductive layer

Please refer to FIG. 1A, in this embodiment, a patterned conductive layer 170 is formed on a surface of the metal insulating layer 160 of the substrate 102. The patterned conductive layer 170 may comprise a contact pad 170a. The contact pad 170a is electrically connected to the light emitting chip 104 through a conductive wire 190. The patterned conductive layer 170 serves as a circuit pattern. Additionally, a carrying portion 170b may be selectively formed on the surface of the metal insulating layer 160 to support the light emitting chip 104 so that the height of a bottom of the light emitting chip 104 is aligned with that of the contact pad 170a. In one embodiment, the light emitting chip 104 may be mounted on the carrying portion 170b by laser soldering the patterned conductive layer 170.

In one embodiment of fabricating the patterned conductive layer 170, a metal material may be formed on the metal insulating layer 160 by an electroplating or magnetron sputtering method to form a patterned conductive layer 170. In another embodiment, a conductive ink may be formed on the metal insulating layer 160 by a screen printing method. Next, the conductive ink may be cured to form a patterned conductive layer 170 on the metal insulating layer 160.

The conductive ink may comprise a conductor filled thermosetting polymer resin ink, for example, a silver paste composite disclosed in US patent Ser. number 5,859,581.

Another embodiment of fabricating the patterned conductive layer 170 comprising a contact pad 170a and a carrying portion 170b, which is closely bonded to the light emitting chip 104, may comprise curing a silver paste using a thermal process with a temperature range from 400°C to 600°C. Generally, adhesion of the silver paste may be improved by mixing in glass powder or resin materials. Preferably, the patterned conductive layer 170 may be formed by the silver paste, which is formed by Indium (In) mixed with silver and glass powder, to improve heat conductivity.

As mentioned before, during formation of the subsequent patterned conductive layer on the substrate 102, the thermal process (from 400°C to 600°C) may damage the thin metal insulating layer, resulting in a leakage path. Therefore, the substrate 102 is not only subjected the hydro-thermal sealing process or cured material sealing process before the patterned conductive layer 170 is formed, but also immersed in an insulating oil after a subsequent patterned conductive layer is formed by the thermal process as shown in FIG. 1D. For example, the substrate 102 may be immersed in a methyl silicone oil to reduce stress difference between the metal substrate 102 and the metal insulating layer 160 at a high temperature. Meanwhile, the insulating oil may fill into the holes 4 again for substrate insulation.

In one embodiment, when the metal insulating layer 160 is formed by anodizing a surface of the substrate 102 (Al substrate 102), and the conductive ink is printed on the metal insulating layer 160 to form a patterned conductive layer 170 by a curing method, the Al substrate 102, with temperature at about 350 °C or below, may be immersed in the insulating oil to reduce stress difference between the metal substrate 102 and the metal insulating layer 160 at a high temperature. Therefore, reducing leakage path of the substrate 102, and improving substrate insulation.

In one embodiment, when the patterned conductive layer 170 (for example, silver paste) is formed on the aluminum oxide layer 160 (for example, Al₂O₃), which is formed by anodizing the Al substrate 102, the aluminum oxide layer 160 is broken with penetration of the silver paste and a leakage path may be formed because of internal stress difference between the Al substrate 102 and the aluminum oxide layer 160 during a high temperature (400°C to 600°C) of the silver paste curing process. Thus, one feature of one embodiment of the invention is that during the silver paste curing process, the substrate 102 may be immerged into insulating oil before the substrate has fully cooled down. The insulating oil may have a temperature range of about 100°C to 150°C, preferably below about 350°C. After the silver high temperature paste curing process, internal stresses generated by the silver paste, the aluminum oxide layer 160 and the Al substrate 102 may be reduced during the cooling procedure of the Al substrate 102. Moreover, the insulating oil filled into the holes may isolate the leakage path of the Al substrate 102. The cooling procedure of the Al substrate 102 may have a range of about 5 minutes to 30 minutes.

The insulating oil film remaining on the surface of the substrate 102 may optionally be removed again. Therefore, leaving no sealing layer or insulating oil film on the substrate 102 or between the patterned conductive layer 170 and the metal insulating layer 160. It should be noted that the sealing layer is formed by the sealing process, and not formed by exposing the substrate 102 to the ambient environment.

### Light emitting module

Referring to FIG. 1A again, in one embodiment, the substrate 102 may comprise a heat dissipation portion 180 on a bottom of the substrate 102, accommodating one or more heat pipes 112 for heat dissipation of the light emitting chip 104. A surface of the heat dissipation portion 180 may comprise one or more recesses 102a to accommodate the heat pipes 112.

In one embodiment, the light emitting module 100 may further optionally comprise a heat dissipation portion 114. The heat dissipation portion 114 is disposed below the substrate 102, wherein the dissipating portion 114 may be closely bonded to the heat pipes 112 and the substrate 102 through corresponding recesses 112a. As shown in FIG. 1A, the bottom surface of the heat dissipation portion 114 may comprise cooling fins or cellular ceramic cooling structures 115 to improve heat dissipation efficiency. If the substrate 102 is formed of silicon carbide (SiC), the substrate 102 can co-fire and integrate with the cellular ceramic cooling structures 11, which are also formed of silicon carbide, by sintering.

### Interface between a reflective structure and a substrate

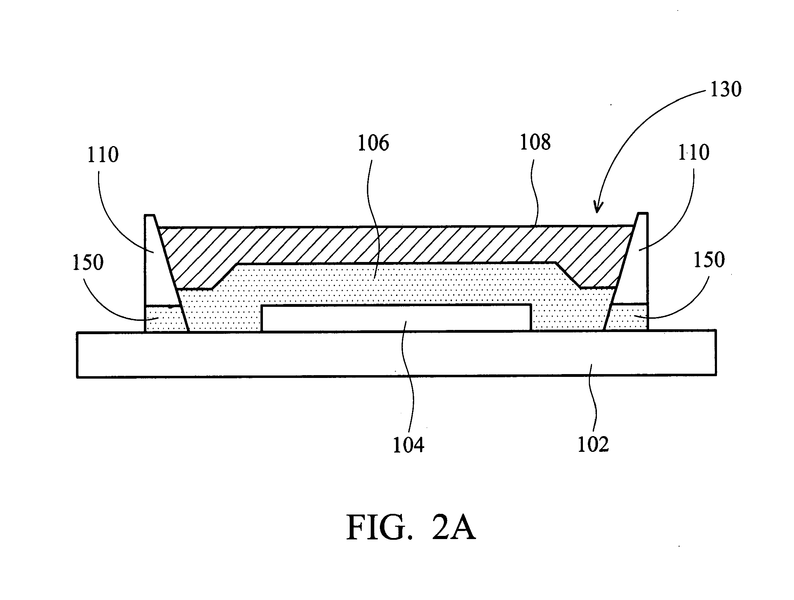

Referring to the light emitting module as shown in FIG. 2A, in one embodiment, a bottom of the reflective structure 110 is bonded on the substrate 102 by an adhesive 150. The adhesive 150, however, has a specific height after curing. Side light emitted from sides of the light emitting chip 104 may be incident into an interface between the reflective structure 110 and the substrate 102. Therefore, it does not matter whether the adhesive 150 is formed of transparent or opaque materials, light incident into the interface between the reflective structure 110 and the substrate 102 will not be reflected by the reflective structure 110. Thus, reducing light emitting efficiency of the light emitting row.

In one embodiment, a plurality of light emitting powders, for example, fluorescent powders, may be mixed into the adhesive 150, for example, a transparent resin. The side light emitting into the interface between the reflective structure 110 and the substrate 102 may react with the light emitting powders in the adhesive 150 to generate another light incident into the light emitting row. Therefore, improving light emitting efficiency of the light emitting row.

### Arrangement of light emitting chips

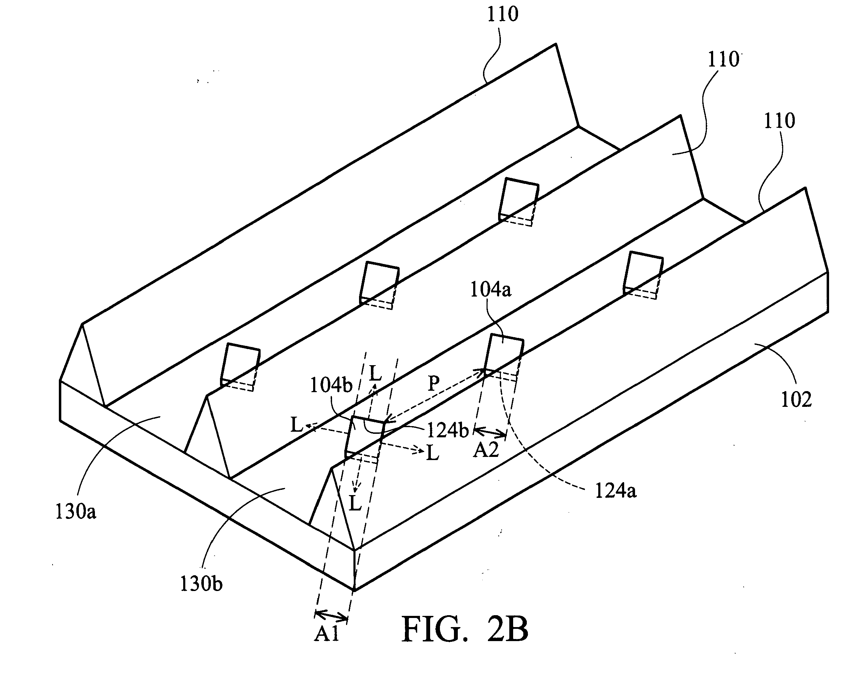

FIG. 2B illustrates an arrangement of an embodiment of light emitting chips in light emitting rows. The conventional light emitting module is formed by a package of a single light emitting chip surrounded by a reflective cup. A multi-chip arrangement is not adopted by the conventional light emitting module because sides of each light emitting chip would block the light emitted from sides of other light emitting chips. Therefore, reducing light emitting efficiency of the light emitting row.

For light emitting efficiency to increase, one embodiment of an arrangement of the unassembled light emitting chips may be used for the aforementioned light emitting module.

The light emitting module may comprise light emitting rows 130a and 130b. Each of the light emitting rows is surrounded by a reflective structure 110. For example, the light emitting row 130b may comprise light emitting chips, for example, light emitting chips 104a and 104b, which are supported by a substrate 102. A side of the reflective structure 110 may comprise a reflective plane to reflect light L emitted from the light emitting chips. Concerning the relationship between two adjacent light emitting chips in the light emitting row 130b, for example, the light emitting chips 104a and 104b have at least one side 124a and 124b, respectively. The side 124a of the light emitting chip 104a has a projection plane substantially, but not fully, overlapped with that of the corresponding side 124b of the light emitting chip 104b. In another embodiment, for high light emitting efficiency requirements, the side 124a of the light emitting chip 104a has a projection plane substantially not overlapped with that of the corresponding side 124b of the light emitting chip 104b. Therefore, achieving maximum light emitting efficiency.

Generally, the term "substantially not fully overlapped" means that an overlapped portion between the projection plane of the side 124a of the light emitting chip 104a and the corresponding side 124b of the light emitting chip 104b is substantially smaller than 90% of the projection plane of the side 124a of the light emitting chip 104a. The term "substantially not overlapped" means that an overlapped portion between the projection plane of the side 124a of the light emitting chip 104a and the corresponding side 124b of the light emitting chip 104b is substantially smaller than 10% of the projection plane of the side 124a of the light emitting chip 104a. The light emitting module has better light emitting efficiency if an overlapped portion between the projection plane of the side 124a of the light emitting chip 104a and the corresponding side 124b of the light emitting chip 104b is substantially smaller than 50% of the projection plane of the side 124a of the light emitting chip 104a. The light emitting module has the maximum light emitting efficiency if an overlapped portion between the projection plane of the side 124a of the light emitting chip 104a and the corresponding side 124b of the light emitting chip 104b is substantially smaller than 50% of the projection plane of the side 124a of the light emitting chip 104a. Generally, the overlapped portion between the projection plane of the side 124a of the light emitting chip 104a and the corresponding side 124b of the light emitting chip 104b is substantially smaller than 70% of the projection plane of the side 124a of the light emitting chip 104a.

Additionally, the light emitting chip may be formed by a polygonal light emitting chip, for example, a rectangular or hexagonal light emitting chip, which is dependant upon chip cutting technology.

In one embodiment, concerning the relationship between the light emitting chips and the reflective structure, greater light emitting efficiency can be achieved if an incident light L is emitted from as much sides of the light emitting chip as possible and substantially faces to a side of the reflective structure with a tilted angle and without being blocked by other light emitting chips. Further, maximum light emitting efficiency can be achieved if an incident light L is emitted from every side of the light emitting chip as possible and substantially faces to a side of the reflective structure with a tilted angle and without being blocked by other light emitting chips. Due to high density light emitting chip requirements, however, a portion of the incident light emitted from sides of the light emitting chip may be blocked by the other light emitting chips. And the blocked percentage may be defined as the described percentage of the overlapped portion.

As shown in FIG. 2B, the two adjacent light emitting chips 104a and 104b may have a minimum distance P, for example, a distance between the two adjacent light emitting chips 104a and 104b. The minimum distance P may be adjusted so that a projection plane A1 of the side of the light emitting chip 104b is substantially not overlapped with or not fully overlapped with a projection plane A2 of the side of the light emitting chip 104a. For example, the overlapped portion is substantially smaller than 10% of the projection plane, preferably 0%. Alternatively, the overlapped portion is substantially smaller than 70% of the projection plane, preferably smaller than 50%. In another embodiment, an arrangement of the light emitting chips may comprise arranging the light emitting chips with proper spacing, and making incident light from every side of at least two adjacent light emitting chips face a side of the reflective structure with a tilted angle. Therefore, achieving greater light emitting efficiency.

In another embodiment, the light emitting chip 104a may be arranged in a diamond arrangement to avoid the projection planes of the adjacent two light emitting chips to be too overlapped and block emitting light. When the light emitting chips are polygonal light emitting chips, the light emitting chips may be arranged in a row with their diagonals, which are respectively formed by extending lines joining two nonadjacent vertices of the light emitting chip, are parallel to the side of the reflective structure 110. For example, each of the light emitting chips may comprise two diagonal vertices. And the two vertices of the light emitting chip are on an axis parallel to an inner side of the reflective structure or on a line parallel to the axis.

In another embodiment, the light emitting chip 104a may be disposed by arranging two adjacent sides of the light emitting chip 104a to face the side of the reflective structure with a tilted angle. Therefore, light emitted from the two adjacent sides of the light emitting chip 104a may face the side of a reflective structure. Additionally, when each side of the light emitting chip has different lengths with each other, the light emitting chip may be disposed by arranging the longest side, which emits light with the largest light emitting area, to face the side of the reflective structure or face the side of the reflective structure with a tilted angle.

The arrangement of the light emitting chips may guide the light emitted from the sides of a light emitting chip to substantially face the reflective plane of the reflective structure without being blocked by other light emitting chips. Therefore, improving light emitting efficiency.

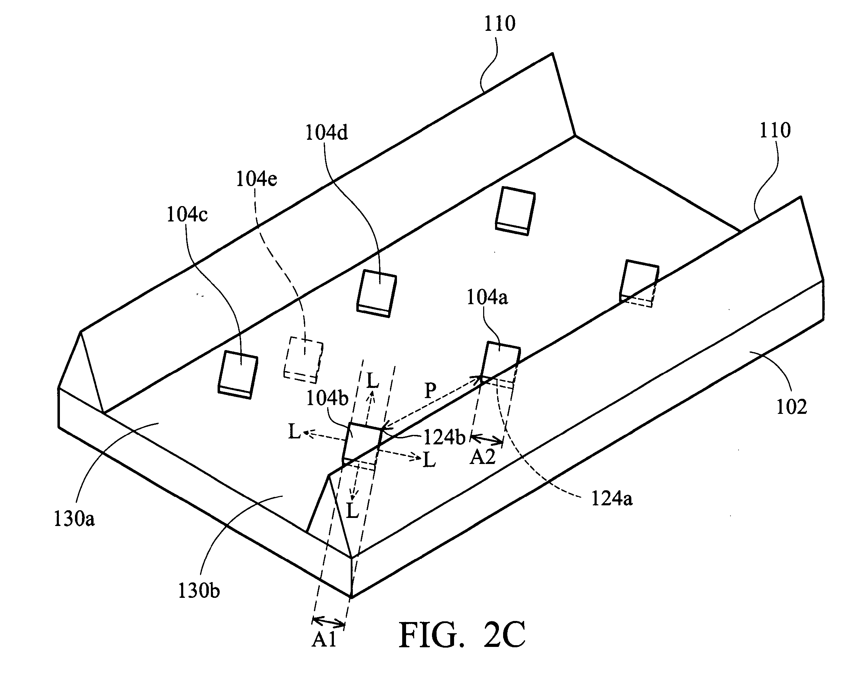

Referring to FIG. 2C, in another embodiment, to further reduce the area of the substrate 102, raise arrangement density of the light emitting chips or enhance the light emitting intensity of a specific light emitting row, at least two rows of light emitting chips 130a and 130b are surround by the reflective structure 110 for heat dissipation and the light emitted from one light emitting chip is not blocked by other light emitting chips. Number of chips, chip density, brightness or color temperature of the two rows of light emitting chips 130a and 130b may be different. The arrangement of a light emitting chip 104e of the two rows of light emitting chips 130a and 130b may be in, for example, dislocation, and are not limited to a side by side or symmetric arrangement.

In another embodiment, adjacent light emitting chips 104a, 104b, 104c and 104d in the two rows of light emitting chips 130a and 130b comprise at least one side. A projection plane of a side of the light emitting chip 104b is substantially not overlapped or not fully overlapped with a projection plane of a corresponding side of the light emitting chip 104c or 104d. For example, the overlapped portion may be smaller than 10% of the projection plane of a side of the light emitting chip 104b, preferably 0%. Alternatively, the overlapped portion may be smaller than 70% of the projection plane of a side of the light emitting chip 104b, preferably 50%. In other embodiments, embodiments of the arrangement of the light emitting chips as shown in FIG. 2B may also used in embodiments of the arrangement of the light emitting chips as shown in FIG. 2C.

### Frame

Referring to FIG. 3, the light emitting module further comprises a frame 310 mounted on the substrate 102. In one embodiment, the frame 310 may be integrated with the reflective structure 110 to surround the light emitting rows, for example, the light emitting rows 130a and 130b. The surface of the substrate 102 on the sides of the frame 310 may comprise a circuit region 300 thereon for electrical connection between the light emitting chips in each light emitting row and a power.

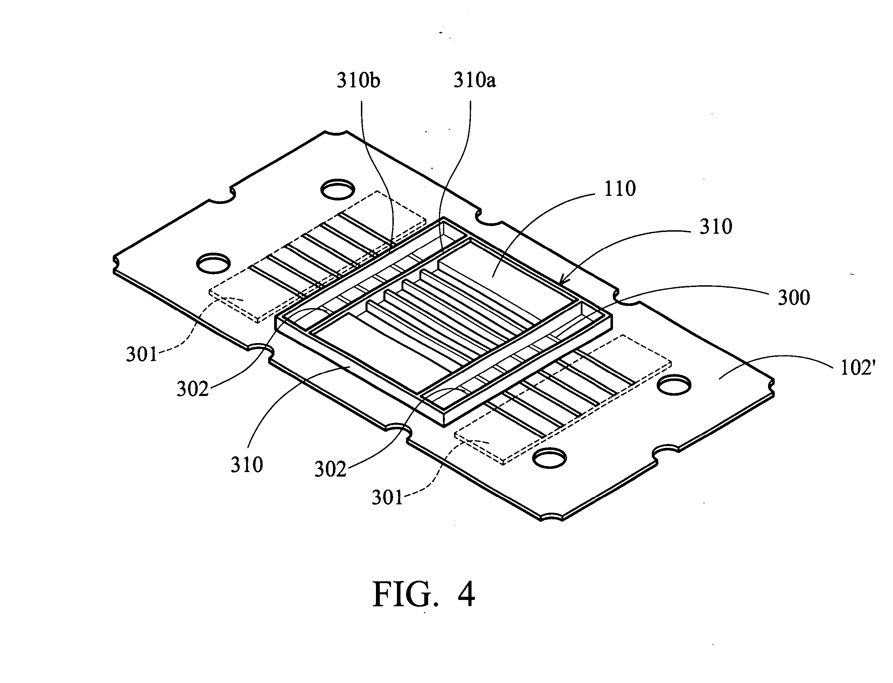

FIG. 4 illustrates a diagram of one embodiment of a light emitting module of the invention. In one embodiment, the frame 310 may comprise an inner frame 310a surrounding the light emitting rows, and an outer frame 310b surrounding the circuit region 300. Additionally, the substrate 102 may be thinned down to form a planar substrate 102' for easier assembly and reduce volume of the light emitting module. Additionally, because one embodiment of the light emitting device is planarized and modulized, the assembly of the light emitting device is improved. To further increase practicable usage of the light emitting device, circuit patterns such as conducting wires 302, which are used to electrically connect to the light emitting chips, may extend to the planar substrate 102' outside of the reflective structure, for example, the substrate 102' outside of the circuit region 300. The conducting wires 302 may be electrically connected to a conductive block 301. The conductive block 301 may be formed by covering a planar copper or aluminum layer on the conducting wires 302. Alternatively, the conductive block 301 may substitute a portion of the conducting wires 302 to connect to the power more easily and reduce resistance of the conducting wires 302.

### Transparent lens

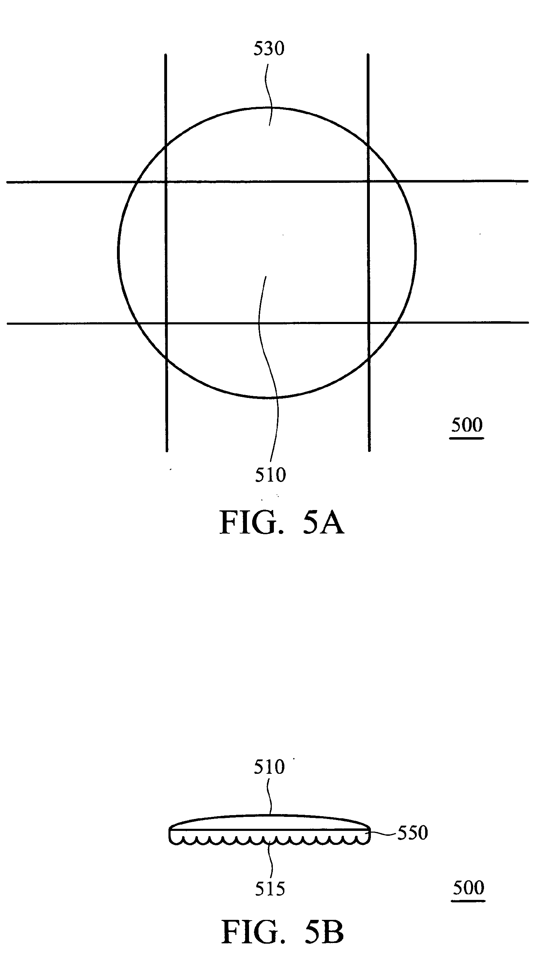

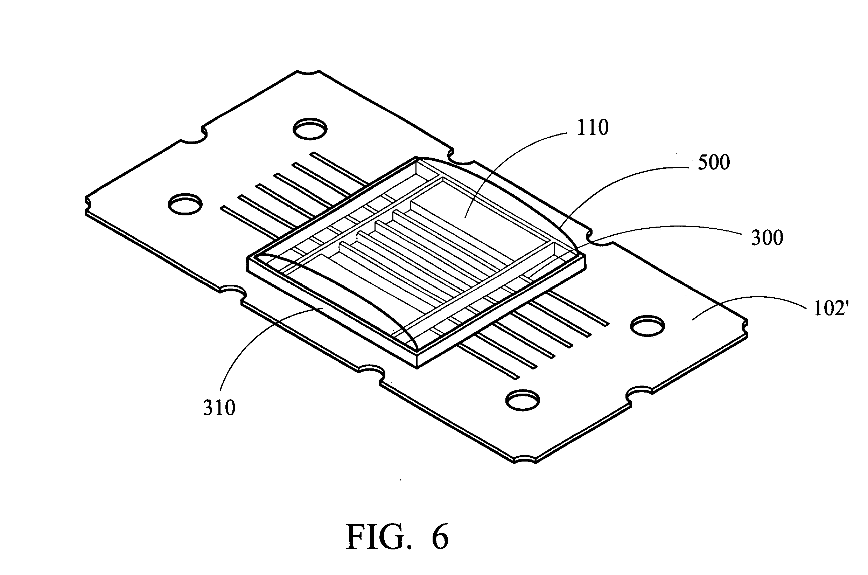

FIGS. 5A, 5B and 6 illustrate an embodiment of a transparent lens 500 of the invention and assembling method thereof. As shown in FIG. 6, in one embodiment, the transparent lens 500 covers the while light emitting rows, mounted on the frame 310 comprising the reflective structure 110. A projective plane of the transparent lens 500, which faces to the substrate 102' may serve as a spotlight region, The projective plane may comprise a polygon plane, for example, a square, hexagon or octagon plane. Each light emitting row may emit uniform light with a circular shape. In one embodiment, the transparent lens 500 may comprise colored transparent lenses to adjust the color temperature of the emitting light.

FIGS. 5A and 5B illustrate fabrication of the transparent lens 500. The fabrication of the transparent lens 500 comprises providing a circular or elliptic transparent lens. Next, the four arc sides 530 are cut and a polygonal transparent lens 510 is left, for example, a rectangular, square or octagonal transparent lens 510. The transparent lens 500 may be bond to a bottom transparent layer 550 to avoid cracking if the transparent lens 500 is too thin.

In one embodiment, a projective plane area of the octagonal transparent lens 510, occupies only half or one-third of a projective plane area of an original circular or elliptic transparent lens. A hexagonal transparent lens 510 may occupy only one-third to half the area of an original circular transparent lens. An additional area may be increased on the substrate 102' to accommodate the circuit region 300.

In one embodiment of an octagonal transparent lens with a smaller size combined with a wider rectangular reflective structure with a larger size, a silicon material is put into a vacuum machine to pump air in the silicon material. Next, the silicon material is coated in a frame between an inner surface of the octagonal transparent lens and the rectangular reflective structure. During bonding of the octagonal transparent lens to the rectangular reflective structure, the unnecessary silicon material and air flows over a gap between edges of the octagonal transparent lens and the rectangular reflective structure. Therefore, the light emitting module is completely formed by filling an inner covering layer between the transparent lens and the light emitting material layer or the protective layer with no air remaining in the closed-chamber.

In other words, reducing the size of one embodiment of the light emitting module. Light emitted from each light emitting row can be formed as a light source through the reflective structure 110 and the transparent lens 500.

Referring to FIG. 5B, in one embodiment, an inner surface 515, which faces the light emitting module, of the transparent lens 500 may be optionally preformed a roughness treatment. Light emitted from each light emitting row would begin to diffuse earlier because the inner surface 515 is close to a light emitting lath of the light emitting chip. Also, bulges, recesses or lines formed on the inner surface 515 by the roughness treatment may increase scattering angle of light after reflection. Therefore, light transmittance of the transparent lens 500 may be improved by 10%. In other words, the rough inner surface 515 of the transparent lens 500 makes light emitted from the light emitting rows have multiple refraction and have about a 180° scattering range. Therefore, softening the light from the light source from the light emitting module for illumination.

### Illumination equipment

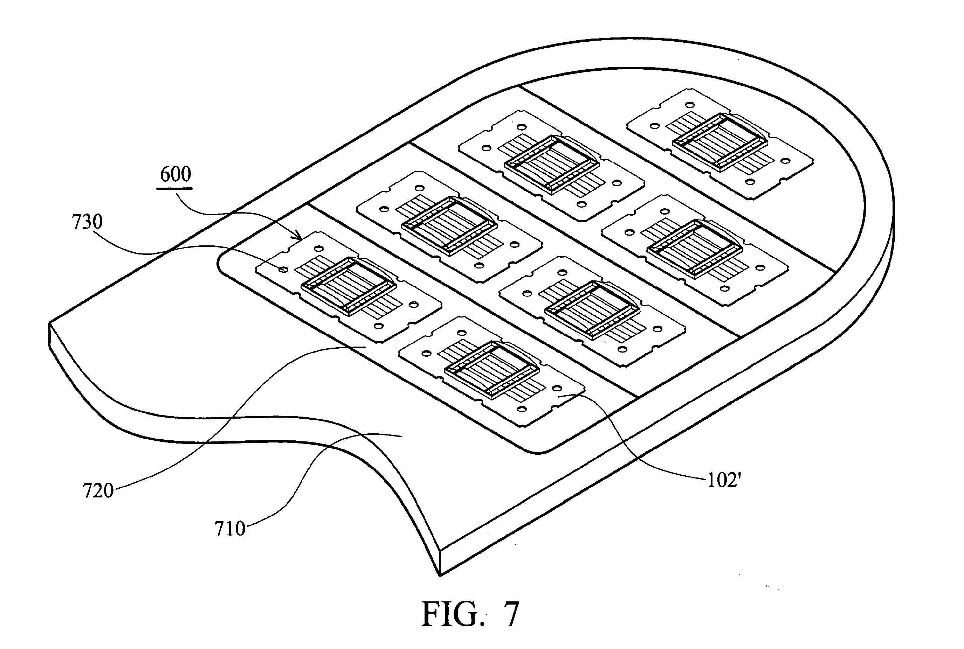

FIG. 7 illustrates an embodiment of illumination equipment, for example, a street light or table lamp, constructed by light emitting modules of the invention. Generally, illumination equipment may comprise a shell body 710 having an opening. A supporting plate 720 is mounted on the opening of the shell body 710 to form an accommodation space. A plurality of light emitting modules 600 is mounted on an outer surface of the supporting plate 720 by a collapsible fixed device 730. For example, light emitting modules 600 are mounted on the outer surface of the supporting plate 720 by using screws, to screw into screw holes of the substrate 102 and the supporting plate 720. In another embodiment, the substrate 102 may serve as a portion of the shell body 710. For example, an aluminum substrate may be used to form the integral shell body 710 and the substrate 102.

### Heat dissipation of the illumination equipment

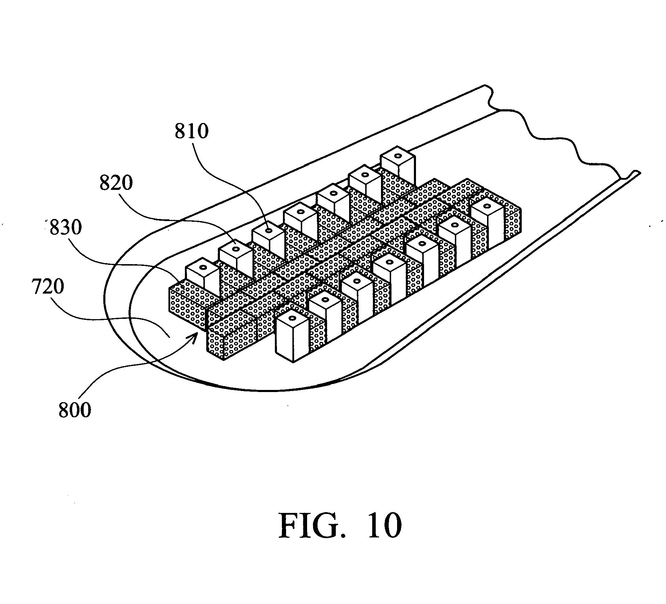

FIGS. 7 and 10 illustrate diagrams showing inner and outer sides of one embodiment of illumination equipment of the invention. One embodiment of illumination equipment of the invention comprises a plurality of light emitting modules 600. Each light emitting module 600 comprises a plurality of light emitting rows and light emitting chips. Therefore, a heat dissipation portion 800 may be disposed on the accommodation space of the shell body. Generally, the heat dissipation portion 800 is commonly used for the entire light emitting chips in the shell body. A heat dissipation area of each light emitting chip may comprise the entire heat dissipation portion 800. Therefore, decreasing the possibility for a single light emitting chip to fail because of less frequent heat dissipation problems.

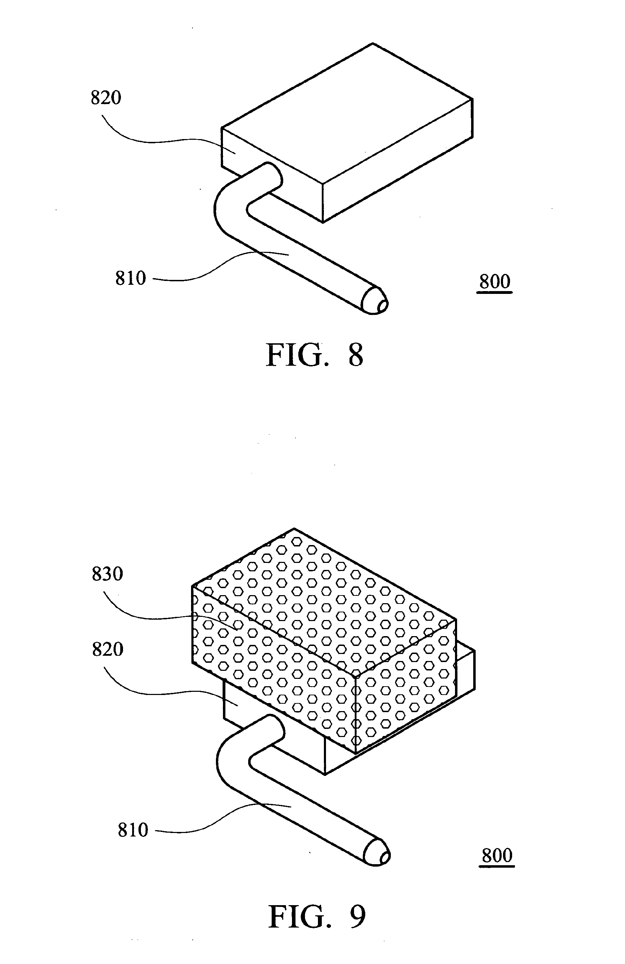

Referring to FIGS. 8 to 10, a heat dissipation path may comprise a substrate 102', the supporting plate 720, which may also serve as a heat dissipation plate, and the heat dissipation portion 800 bonded to an inner side of the supporting plate 720. The heat dissipation portion 800 may comprise one or more heat pipes 810 and heat slugs 820. In one embodiment, the heat pipe 810 is L-shaped. Therefore, one side of the heat pipe 810 may be bonded to the inner side of the supporting plate 720. Another side of the heat pipe 810 may be formed through the heat slugs 820 for heat transmission of the light emitting module to the heat slugs 820, and the heat slugs 820 may also be bonded to the inner surface of the supporting plate 720 to dissipate heat from the supporting plate 720. The heat dissipation path may extend to an outer apparatus outside of the shell body. Additionally, a heat dissipation device may not have power bonded on the shell body or in the accommodation space to increase heat dissipation efficiency. A film oscillating device, for example a metal or alloy leaf spring, may be disposed in the accommodation space of the chamber. When heat of the light emitting module transfers to the accommodation space, air in the accommodation space may have a disturbed flow because the film oscillating device may oscillate because of temperature difference, which causes the film oscillating device to expand when hot and to shrink when cold. Therefore, heat dissipation efficiency is improved. In another embodiment, a wind power or thermal power (solar power) driven van may be optionally disposed outside of the shell body to reduce the temperature of the shell body using natural wind or thermal energy in the atmosphere.

In one embodiment, the heat pipes 810 may increase heat dissipation efficiency. The heat pipes 810 may comprise a body having a vacuum chamber. The body may be formed of heat dissipation materials, for example, copper or aluminum. The vacuum chamber is filled with a heat transfer fluid, for example, water or wick, distributed on the inner side of the vacuum chamber. Therefore, when the heat transfer fluid in the heat pipes 810 is close to a heat source, the heat transfer fluid may flow to two ends of the body. Next, the heat transfer fluid on the two ends of the body is cooled. The cooling heat transfer fluid is then pulled back to a location of the heat source again by capillarity for heat transference. The heat slugs 820 and the supporting plate 720 is generally formed by metals with good heat dissipation efficiency, for example, aluminum, copper or alloys.

Additionally, referring to FIGS. 9 and 10, in another embodiment, the heat dissipation portion 800 may further comprise a heat dissipation device 830, for example, a cooling fin. The heat dissipation device 830 is generally formed by copper. As shown in FIG. 9, in another embodiment, the heat dissipation device 830 may optionally comprise a cellular ceramic cooling structure sintered by silicon carbide (SiC). As shown in FIG. 10, the heat dissipation device 830 may be bonded to the heat slugs 820 and the supporting plate 720 to achieve better heat dissipation efficiency. An adhesive for bonding the heat dissipation portion 800 and other heat dissipation devices is chosen under consideration for heat dissipation efficiency to avoid blocking the heat dissipation path. In one embodiment, putty, comprising unsaturated polyester may serve as the adhesive.

### Light emitting row of a light emitting module

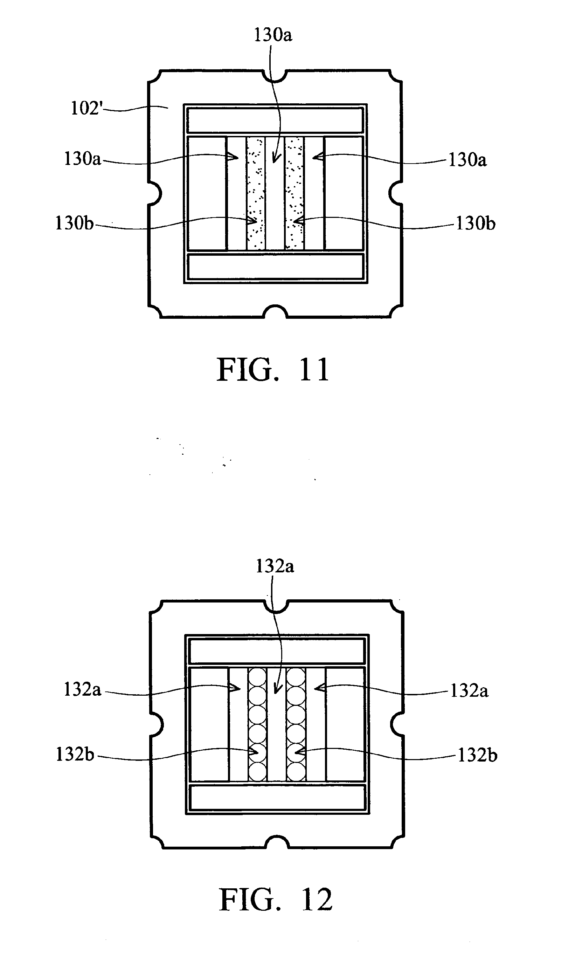

Referring to FIGS. 11 and 12, one embodiment of the light emitting module may comprise a plurality of light emitting rows. Optionally, a first light emitting row may be chosen to emit a first light with a first color temperature, and a second light emitting row may emit a second light with a second color temperature. The first light and the second light are mixed by a transparent lens to form a third light with a third color temperature. In another embodiment, the first light and the second light are mixed by a colored transparent lens to form a third light with a third color temperature. The colored transparent lens may have a color harmony effect in different color temperatures. The third color temperature is between the first and second color temperatures.

As shown in FIG. 11, for the case of a white light illumination device, a plurality of light emitting rows with different color temperatures may be disposed on a substrate 102'. The reflective structure and the transparent lens may mix light emitted from the light emitting rows with different color temperatures, forming a mixed light source. Therefore, the color temperature of the light emitted from each light emitting row may be adjusted to achieve color temperature requirements of the mixed light source. For example, a warmer light source has a color temperature below about 3000 K, a middle light source has a color temperature of about 3000 K to 6500 K, and a colder light source has a color temperature above about 6500 K. In one embodiment, for a white light illumination device, a percentage of a lower color temperature light emitting row 130a may be greater than that of a higher color temperature light emitting row 130b.

FIG. 12 illustrates another embodiment of light emitting row with different color temperatures. For example, white light emitting rows 132a that cover a light emitting material may be arranged with red yellow (low color temperature) or blue (high color temperature) light emitting rows 132b, without covering a light emitting material to form a warmer light source with lower color temperature or colder light source with higher color temperature.

### Light emitting module manufacturing method

A method for manufacturing one embodiment of a light emitting module is provided. The method for manufacturing one embodiment of a light emitting module comprises the steps described as below. The sequence of the steps can be adjusted for manufacturing process requirements and is not limited to the disclosed embodiments.

Referring to FIGS. 1A to 1D, a substrate 102 is provided. The substrate 102 may comprise metal substrates, for example, aluminum substrates. An anodizing process is performed on the substrate 102 to form an aluminum (A1) substrate having a planarized aluminum oxide layer 160. The planarized aluminum oxide layer 160 may comprise a plurality of holes 4. Next, the substrate 102 is immersed in an insulating oil to form an insulating oil film 6 that covers a top surface of the aluminum oxide layer 160 and the holes 4. The insulating oil film on the top surface of the aluminum oxide layer 160 is then removed. Next, a patterned conductive layer 170 is formed on a surface of the substrate 102, and light emitting chips 104 arranged in rows on the substrate 102 or a carrying portion 170b are mounted. An arrangement of the light emitting chips comprise light emitted from sides of the light emitting chips to face a side of a reflective structure, by reducing an overlapped portion of a projection plane of one light emitting chip and other light emitting chips. In one embodiment as shown in FIGS. 2B and 2C, during a cooling procedure of the substrate 102, the substrate 102 may be immerged into an insulating oil 6 having a temperature range below about 300°C, for example, 100°C to 150°C, to reduce internal stresses among different material layers. Next, the holes 4 may be filled by the insulating oil film again to prevent generation of a possible leakage path 5. The insulating oil film on the metal oxide layer is then removed.

Next, referring to FIGS. 1A, 2A to 2C, one embodiment of a light emitting module may comprise a reflective structure 110 having a plurality row spaces. The reflective structure 110 may be formed by a plastic reflective structure with a reflective plane, for example, a Cr or Ag, coating thereon. The reflective structure 110 is disposed on the substrate 102 to accommodate light emitting chips 104 of the light emitting rows. The reflective structure 110 may be integrated on a frame 310 as shown in FIG. 4. The frame 310 may comprise an inner frame 310a and an outer frame 310b. A plurality of fluorescent powders may be mixed into the adhesive, which is used to bond the reflective structure 110 and the substrate 102. The side light emitting into the interface between the reflective structure 110 and the substrate 102 may react with the fluorescent powders in the adhesive to generate another light incident into the light emitting row.

After performing a wire bonding process for electrical connection of the light emitting chips 104 and the patterned conductive layer 170, fluorescent powders may be coated in the row spaces of the light emitting rows by a spray coating method. Alternatively, the fluorescent powders may be mixed with a liquid without adhesive to form a composite liquid. Next, the composite liquid is filled in the inner frame 310a of the reflective structure 110 by using, for example, a dropping method,. The composite liquid is then removed using, for example, a baking method. The fluorescent powders may be clotted by Van der Waals force to form a light emitting material layer 106. The light emitting material layer 106 may be attached to the light emitting chips 104 of the reflective structure 110. Therefore, the light emitting material layer 106 may be formed, wherein the light emitting material layer 106 may continuously cover the light emitting chips 104 and extend to an inner wall of the reflective structure 110.

One embodiment of the fluorescent powders may be nanorized by uniform mixing with a liquid without adhesive to form a composite liquid. Another mixing method for uniformity is to mix an organic solvent with the liquid without adhesive so that mixing with the fluorescent powders are more uniform. Next, the liquid and the organic solvent are removed to clot the fluorescent powders, forming a fluorescent powder layer. The fluorescent powder layer may attach to the light emitting chips 104 of the reflective structure 110. For example, the organic solvent may comprise paraffin wax or resin oil. The organic solvent may be removed by a thermal process with a temperature of about 450°C .

The reflective structure 110 according to one embodiment of the invention may improve deposition velocity of the fluorescent powders by the conventional deposition method. The reflective structure 110 may allow a little composite liquid to remain on the inner frame 310a. The remaining composite liquid may be removed more quickly to form a light emitting material layer 106 by a baking method. The light emitting material layer 106 may attach to the light emitting chips 104 of the reflective structure 110. Therefore, improving process efficiency.

In one embodiment, to avoid peeling of the light emitting material layer 106, the inner covering layer 108 may be formed by filling a silicon protective layer or an epoxy layer or embedding a hard glass layer in the reflective structure 110, and then laminating the light emitting material layer 106. As shown in FIG. 6, a transparent lens 500 is provided covering the entire reflective structure 110. The transparent lens 500 may have a rectangular or polygonal shape by cutting to reduce an occupied area of the substrate. A closed-chamber between the transparent lens 500 and the reflective structure 110 may be filled with another inner covering layer to avoid water vapor permeation. Alternatively, the inner covering layer may be formed by filling silicon to cover the light emitting material layer 106, and fill the closed-chamber after covering the transparent lens 200 on the reflective structure 110. Therefore, forming an integral inner covering layer without interface. The aforementioned planarized light emitting modules may be constructed with a supporting plate 720 of a shell body as shown in FIG. 7, by a collapsible method to form a light emitting system.

While the invention has been described by way of example and in terms of the embodiments, it is to be understood that the invention is not limited to the disclosed embodiments. To the contrary, it is intended to cover various modifications and similar arrangements (as would be apparent to those skilled in the art). Therefore, the scope of the appended claims should be accorded the broadest interpretation so as to encompass all such modifications and similar arrangements.

### BRIEF DESCRIPTION OF numerals IN THE DRAWINGS as below

- 100 :: light emitting module;
- 102 - 102' :: substrate;
- 104 :: light emitting chips;
- 106:: light emitting material layer;
- 110 :: reflective structure;
- 108 :: inner covering layer;
- 200 :: transparent lens;
- 130 :: light emitting row;
- 160 :: metal insulating layer;
- 180 :: heat dissipation portion;
- 112 :: heat pipe;
- 102a :: recess;
- 114 :: heat dissipation portion;
- 115 :: cooling fin;
- 170 :: patterned conductive layer;
- 170a :: contact pad;
- 190 :: conductive wire;
- 170b :: carrying portion;
- 112a :: recess;
- 150 :: adhesive;
- 130a - 130b - 132a - 132b :: light emitting row;
- 104a∼104e :: light emitting chip;
- 124a - 124b :: side;
- L :: incident light;
- P :: minimum distance;
- A1 :: projection plane;
- A2 :: projection plane;
- 310 :: frame;
- 300 :: circuit region;
- 310a :: inner frame;
- 310b :: outer frame;
- 500 :: transparent lens;
- 530 :: arc side;
- 510 :: polygonal transparent lens;
- 550 :: bottom transparent layer;
- 515 :: inner surface;
- 600 :: light emitting module;
- 720 :: supporting plate;
- 710 :: shell body;
- 730 :: fixed device;
- 810 :: heat pipe;
- 820 :: heat slug;
- 830 :: heat dissipation device.

## Claims

1. A light emitting system comprising at least a light emitting module, **characterized by** comprising:
a substrate;
light emitting rows supported by the substrate, wherein each light emitting row has unassembled light emitting chips, surrounded by a reflective structure; and
a transparent lens disposed above the light emitting rows for mixing lights emitted from the light emitting rows to form a light source.

2. The light emitting system as claimed in claim 1, **characterized by** the light emitting module further comprises a light emitting material layer in at least one of the light emitting rows, covering the unassembled light emitting chips.

3. The light emitting system as claimed in claim 2, **characterized by** the light emitting material layer further comprises light emitting powders, wherein at least one part of the light emitting powders is clotted without adhesive.

4. The light emitting system as claimed in claim 2, **characterized by** the light emitting module further comprises a protective layer mounted in the reflective structure, covering the light emitting material layer.

5. The light emitting system as claimed in claim 2, **characterized by** the light emitting material layer continuously covers the unassembled light emitting chips, and extends to an inner wall of the reflective structure.

6. The light emitting system as claimed in claim 1, **characterized by** a bottom of the reflective structure is bonded to the substrate by an adhesive, and the adhesive is mixed with light emitting powders.

7. The light emitting system as claimed in claim 1, **characterized by** a first light emitting chip and an adjacent second light emitting chip of at least one of the light emitting rows have a minimum distance, and each of the first light emitting chips and the second light emitting chips comprises at least one side, wherein the minimum distance makes a projection plane of the side of the first light emitting chip and the side of the second light emitting chip substantially not overlapped.

8. The light emitting system as claimed in claim 1, **characterized by** a first light emitting chip and an adjacent second light emitting chip of at least one of the light emitting rows have a minimum distance, and each of the first light emitting chips and the second light emitting chips comprises at least one side, wherein the minimum distance makes an overlapped portion between a projection plane of the side of the first light emitting chip and the side of the second light emitting chip substantially smaller than 70% of the projection plane of the side of the first light emitting chip.

9. The light emitting system as claimed in claim 1, **characterized by** a light emitting chip of at least one of the light emitting rows comprises sides, and light emitted by each side of the light emitting chip faces to a side of the reflective structure without being blocked by the other light emitting chips.

10. The light emitting system as claimed in claim 1, **characterized by** the light emitting chip of at least one of the light emitting rows comprises two vertices on a diagonal, and the two vertices are on an axis parallel to the reflective structure or on a line parallel to the axis.

11. The light emitting system as claimed in claim 1, **characterized by** the light emitting rows comprise a light emitting row emitting light with greater color temperature and a light emitting row emitting light with lower color temperature.

12. The light emitting system as claimed in claim 1, **characterized by** at least one light emitting row, covered by a light emitting material layer and in the reflective structure, emits a first light, and at least one light emitting row not comprising the light emitting material layer emits a second light, wherein the first light and the second light are mixed by the transparent lens to form a third light.

13. The light emitting system as claimed in claim 1, **characterized by** the substrate comprises a metal substrate, and the substrate further comprises a metal insulating layer thereon, and the metal insulating layer further comprises a patterned conductive layer to electrically connect the light emitting chips, wherein an interface between the patterned conductive layer and the metal insulating layer does not comprise a sealing layer or an insulating oil film.

14. The light emitting system as claimed in claim 13, **characterized by** the metal insulating layer has holes, and the holes are covered by an insulating oil film.

15. The light emitting system as claimed in claim 14, **characterized by** a top surface of the metal insulating layer totally does not comprise the sealing layer or an insulating oil film formed thereon.

16. The light emitting system as claimed in claim 13, **characterized by** the substrate comprises an aluminum substrate, and the metal insulating layer comprises a porous aluminum oxide layer without a hydro-thermal sealing process or cured material sealing process.

17. The light emitting system as claimed in claim 13, **characterized by** the patterned conductive layer is formed by curing a silver paste.

18. The light emitting device as claimed in claim 15, **characterized by** there is a gap between each substrate of the light emitting units, avoiding heat accumulation.

19. The light emitting system as claimed in claim 1, **characterized by** the substrate is formed by a silicon carbide material.

20. The light emitting system as claimed in claim 1, **characterized by** a projection plane of the transparent lens facing to the substrate has a polygonal shape.

21. The light emitting system as claimed in claim 20, **characterized by** a first light emitting row emits a first light with a first color temperature, and a second light emitting row emits a second light with a second color temperature, and the first light and the second light are mixed by the transparent lens to form a third light with a third color temperature, wherein the third color temperature is between the first and second color temperatures.

22. The light emitting system as claimed in claim 1, **characterized by** the transparent lens comprises rectangular, square, hexagonal or octagonal transparent lens, and the substrate outside of the transparent lens further comprises a circuit region thereon.

23. The light emitting system as claimed in claim 22, **characterized by** the light emitting module further comprises a frame mounted on the substrate, the frame comprises an inner frame surrounding the light emitting rows serving as a reflective structure, and an outer frame surrounds the circuit region.

24. The light emitting system as claimed in claim 23, **characterized by** a dimension of the transparent lens is smaller than the frame, and an inner surface of the transparent lens facing to the light emitting rows is a rough surface.

25. The light emitting system as claimed in claim 1, **characterized by** the light emitting module further comprises:
a circuit pattern on the substrate to electrically connect to the light emitting chips, and extend to a region of the substrate outside of the reflective structure; and
a conductive block on the region of the substrate outside of the reflective structure to electrically connect to the circuit pattern.

26. The light emitting system as claimed in claims 1 to 25, **characterized by** further comprising:
a shell body having a opening;
a supporting plate mounted on the opening of the shell body to form an accommodation space, wherein the light emitting module is mounted on an outer side of the supporting plate by a collapsible method, and the accommodation space comprises a heat dissipation portion therein and is bonded to an inner side of the supporting plate.

27. The light emitting system as claimed in claim 26, **characterized by** the heat dissipation portion further comprises:
heat pipes bonded to the inner side of the supporting plate, wherein the supporting plate serves as a heat dissipation plate; and
heat slugs bonded to the inner side of the supporting plate with the heat pipes embedded therein.

28. The light emitting system as claimed in claim 27, **characterized by** further comprising cooling fins or a cellular ceramic cooling structure bonded to the inner side of the supporting plate and the heat slugs.

29. The light emitting system as claimed in claim 26, **characterized by** further comprising a heat dissipation device without power bonded on the shell body or in the accommodation space.

30. The light emitting system as claimed in claim 1, **characterized by** the light emitting row surrounded by at least one the reflective structure comprises at least two light emitting chips.

31. The light emitting system as claimed in claim 1, **characterized by** one light emitting chip of at least one the light emitting rows comprises two connecting sides, and the two connecting sides face a sidewall of the reflective structure with a tilted angle.

32. The light emitting system as claimed in claim 1, **characterized by** one light emitting chip of at least one the light emitting rows comprises a long side and a short side, and a light emitted from the long side of the light emitting chip substantially faces a sidewall of the reflective structure or faces a sidewall of the reflective structure with a tilted angle, without being blocked by the other light emitting chips.
